Europäisches Patentamt

European Patent Office

Office européen des brevets

(19)

(11) Veröffentlichungsnummer: **0 206 980**
**B1**

(12) **EUROPÄISCHE PATENTSCHRIFT**

(45) Veröffentlichungstag der Patentschrift: **13.06.90**

(21) Anmeldenummer: **86810187.4**

(22) Anmeldetag: **25.04.86**

(51) Int. Cl.⁵: **H 01 L 23/36,** B 21 D 19/08,
H 01 L 21/48, B 23 P 11/00,
B 21 K 25/00

(54) Kühlkörper für Halbleiterbauelemente und Verfahren zu seiner Herstellung.

(30) Priorität: **22.05.85 DE 3518310**

(43) Veröffentlichungstag der Anmeldung:
**30.12.86 Patentblatt 86/52**

(45) Bekanntmachung des Hinweises auf die
Patenterteilung:
**13.06.90 Patentblatt 90/24**

(84) Benannte Vertragsstaaten:
**AT BE CH DE FR GB LI LU NL SE**

(56) Entgegenhaltungen:
**DE-A-2 502 472
DE-U-8 429 523
US-A-2 984 774**

**PATENT ABSTRACTS OF JAPAN, Band 7, Nr. 45
(E-160)1190r, 23. Februar 1983 & JP - A - 57 196
552**

(73) Patentinhaber: **ALUSUISSE-LONZA SERVICES
AG
Feldeggstrasse 4
CH-8034 Zürich (CH)**

(72) Erfinder: **Bock, Uwe
Richard Wagner Strasse 51
D-7700 Singen (DE)**

Courier Press, Leamington Spa, England.

EP 0 206 980 B1

## Beschreibung

Die Erfindung betrifft ein Verfahren zur Herstellung eines Kühlkörpers für Halbleiterbauelemente gemäss dem Oberbegriff von Anspruch 1.

Ein Verfahren dieser Art offenbart DE—A—25 02 472; die Grundplatte wird mit Nuten hergestellt, deren Wände in ihrer Längsrichtung mit herausgepressten Wandrippen versehen sind. In diese Nuten werden Kühlrippen mit vertikaler Riffelung eingepresst und zwar auf dem Wege des Kaltpressschweissens. Durch die erforderlichen hohen Kräfte, die beim Kaltpressschweissvorgang angewendet werden müssen, ist die Länge der entstehenden Kühlkörper stark begrenzt; auch ist eine Mindestdicke der Kühlrippen erforderlich, um deren Abknicken beim Kaltpressschweissvorgang zu vermeiden.

Doch nicht nur die entstehenden Kräfte begrenzen die Kühlkörperlänge: Durch die vertikale Riffelung der Kühlrippen ist deren entlang der Grundplatte gemessene Länge durch das Mass des Strangpresswerkzeuges begrenzt, da die Pressrichtung gleich der Riffelungsrichtung ist.

Aus JP—A—57 196 552 ist zudem grundsätzlich bekannt, Kühlrippen in die Nuten eines Grundkörpers einzupressen.

DE—U—84 29 523 offenbart eine Verfahren, bei welchem in Zwischennuten eines Kühlkörpers mit angeformten Kühlrippen die Kühlrippen eines zweiten Kühlkörpers eingepresst werden.

Aus US—A—2 984 774 ist weiter bekannt, Kühlrippen zur Oberflächenvergrösserung mit seitlichen Rippen zu versehen.

Angesichts dieses Standes der Technik hat sich der Erfinder die Aufgabe gestellt, ein Verfahren zur Herstellung eines Kühlkörpers zu schaffen, dank dem ein hohes Rippenverhältnis erzielt und so ein sogenannter Hochleistungskühlkörper beliebiger Länge hergestellt zu werden vermag. Unter dem Rippenverhältnis wird das Verhältnis der Rippenhöhe zum kleinsten lichten Rippenabstand im Bereich der Rippenspitzen verstanden.

Erfindungsgemäss wird die Aufgabe gelöst durch die kennzeichnenden Merkmale von Anspruch 1. Weitere Merkmale ergeben sich aus den Unteransprüchen.

Beim Verbinden der in beliebiger Länge vorgefertigten Einzelteile entstehen keine hohen Pressdrücke; die Kühlrippen können in die Nuten sogar mit Spiel eingelegt und darin problemlos in Richtung der Nuten verschoben werden.

Durch die Kombination von Grundplatte und Rippen kann mit wenigen Werkzeugen eine Vielzahl von Kühlkörpern unterschiedlicher Ausgestaltung hergestellt werden. Dies führt zu einer Verminderung der Kosten sowohl bezüglich der Werkzeuge als auch der Lagerhaltung.

Die Grundplatte kann mit seitlichen Rippenwänden versehen sein, welche leicht auf dem Wege des Strangpressens erzeugt werden können. Zwischen diesen Rippenwänden und zu ihnen parallel verlaufen dann die eingesetzten Kühlrippen.

Bei einer anderen Ausführungsform wechseln sich im Querschnitt des Kühlkörpers gesondert eingesetzte Kühlrippen mit anderen Kühlrippen ab, die zusammen mit der Grundplatte einstückig geformt worden sind. Eine derartige Kühlkörperform ermöglicht den Einsatz sowohl bei Zwangsbelüftung als auch bei Konvektionskühlung; während bei Zwangsbelüftung grundsätzlich eine größtmögliche Oberfläche durch geringen Rippenabstand angestrebt wird, ist dies bei Konvektionskühlung zumindest bei längeren Kühlkörpern wegen der geringen Luftgeschwindigkeit — und damit Luftmenge (Produkt aus Geschwindigkeit und Kanalquerschnitt) — kaum wirksam. Diese variable Einsatzmöglichkeit wird noch dadurch vergrößert, daß beispielsweise die eingesetzten Kühlrippen mit an sich bekannten Querrippen versehen sien können, die bei einem relativ breiten Strömungskanal zu einer erheblichen Oberflächenvergrößerung führen. Es wird erkennbar, daß dieser Kühlkörper nicht nur für die Zwangsbelüftung geeignet ist, sondern auch für Konvektionskühlung.

Jede Hauptnut ist beidseits von Zwischennuten flankiert, wobei bevorzugt die Hauptnut von etwa rechteckigem Querschnitt ist und die Zwischennut von i.w. dreiecksförmigem Querschnitt. Ebenso ist die Tiefe der Hauptnut größer als jene der Zwischennut, denn letztere dient als Hilfseinrichtung für das Verformen der Grundplatte. Haupt- und Zwischennut erzeugen zwischen sich eine Rippe der Grundplatte, welche beim Einsetzen eines verformenden Werkzeuges in die Zwischennut in den lichten Querschnitt der Hauptnut eingeschoben werden kann. Vor diesem plastischen Verformen jener Rippe der Grundplatte ist in die Hauptnut der Sockel einer gesondert hergestellten Kühlrippe eingesetzt worden, der seitlich mit Retentionen versehen ist, beispielsweise mit ein Sägezahnprofil erzeugenden Parallelnuten, in die ein Teil der verformten Grundplattenmatrix haltend eingreift. Es entsteht so eine sehr feste und dennoch ohne Probleme herzustellende vorschüssige Verbindung zwischen Grundplatte einerseits und Kühlrippe andererseits.

In der Regel wird beim reinen Aluminium-Kühlkörper mit entsprechender Grundplattendicke die Wärmeverteilung in der Grundplatte selbst ausreichend sein. Da jedoch bei gleicher Kühlkörperhöhe die Rippenoberfläche mit zunehmender Grundplattendicke reduziert wird, kann es erforderlich werden, die Wärmeverteilung in der Grundplatte selbst zu verbessern. Dies wird erfindungsgemäß dadurch erreicht, daß die Grundplatte mit wenigstens einem Band, einem Draht od. dgl. Ein- oder Auflage aus hochwärmeleitendem Werkstoff versehen ist, bevorzugt mit einem Kupferband oder Kupferdraht. Auch hier zeigt sich der Vorzug der getrennten Herstellung der Grundplatte, da diese problemlos auf dem Wege des Verbundstrangpressens aus Aluminiumkörper und Kupferauflage oder Kupfereinlage hergestellt werden kann und zwar unter metallischem Verbund beider Profilkomponenten. Die beschriebenen Ausführungsformen von erfindungsgemäßen Kühlkörpern erlauben ein Rippenverhältnis von mehr als 9:1, sogar mehr als 12:1, wie dies bei einstückig hergestellten Kühlkörpern nicht zu erzielen ist.

In diesem Zusammenhang sei ergänzend auf die DE—OS 30 24 748 hingewiesen, mit der für einen einstückigen Kühlkörper vorgeschlagen wird, dessen ein niedriges Rippenverhältnis aufweisende Kühlrippen durch klammerartige Profileinsätze zu ergänzen.

Beim erfindungsgemässen Verfahren zum Herstellen von Kühlkörpern der eingangs erwähnten Art wird die Grundplatte mit Hauptnuten stranggepreßt, in die Hauptnuten werden gesondert hergestellte Kühlrippen eingesetzt und durch einen Quetschvorgang mit der Grundplatte verbunden. Dazu werden mit den Hauptnuten diese flankierende und von Zwischennuten trennende Rippen hergestellt und letztere nach dem Einsetzen jener Kühlrippen plastisch verformt.

Eine Verformung jener Rippen kann durch den einfachen Einsatz von Meißeln erfolgen, was jedoch verhältnismäßig hohe Arbeitskosten verursacht. Deshalb wird für diesen Verformungsvorgang ein Wekzeug vorgeschlagen, welches durch von Distanzeinlagen in Abstand gehaltenen Druckscheiben mit sich radial verjüngenden Druckkanten gekennzeichnet ist, wobei die freie radiale Länge der Druckscheiben größer ist als die freie Höhe der Kühlrippen und der mittlere Abstand der Druckscheiben voneinander dem Abstand eines Paares freier Zwischenrippen der Grundplatte entspricht. Dank dieses Werkzeuges ist der Verformvorgang automatisierbar, darüberhinaus kann der erfindungsgemäße Rollenkörper auf die jeweilig gewünschte Rasterung der Zwischenrippen eingestellt werden.

Es ist erkennbar, daß das Herstellen von Kühlkörpern mit hohem Rippenverhältnis nunmehr ohne das Risiko eines Werkzeugbruches in einfacher Weise möglich wird.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in

Fig. 1 eine geschnittene Schrägsicht auf einen Teil eines Kühlkörpers;

Fig. 2 einen Teilschnitt durch einen Kühlkörper:

Fig. 3 ein vergrößertes Detail der Fig 2;

Fig. 4 eine Skizze zu einem Herstellungsverfahren für den Kühlkörper nach Fig. 1,2 im schematisierten Querschnitt;

Fig. 5 einen vergrößerten Ausschnitt aus Fig. 4;

Fig. 6 den Querschnitt druch einen anderen Kühlkörper;

Fig. 7 einen vergrößerten Ausschnitt aus Fig. 6 nach deren Feld VII;

Fig. 8 den Querschnitt durch eine weitere Ausführungsform des Kühlkörpers;

Fig. 9 bis Fig. 11 Querschnitte durch unterschiedliche Ausführungsformen eines Teils eines Kühlkörpers.

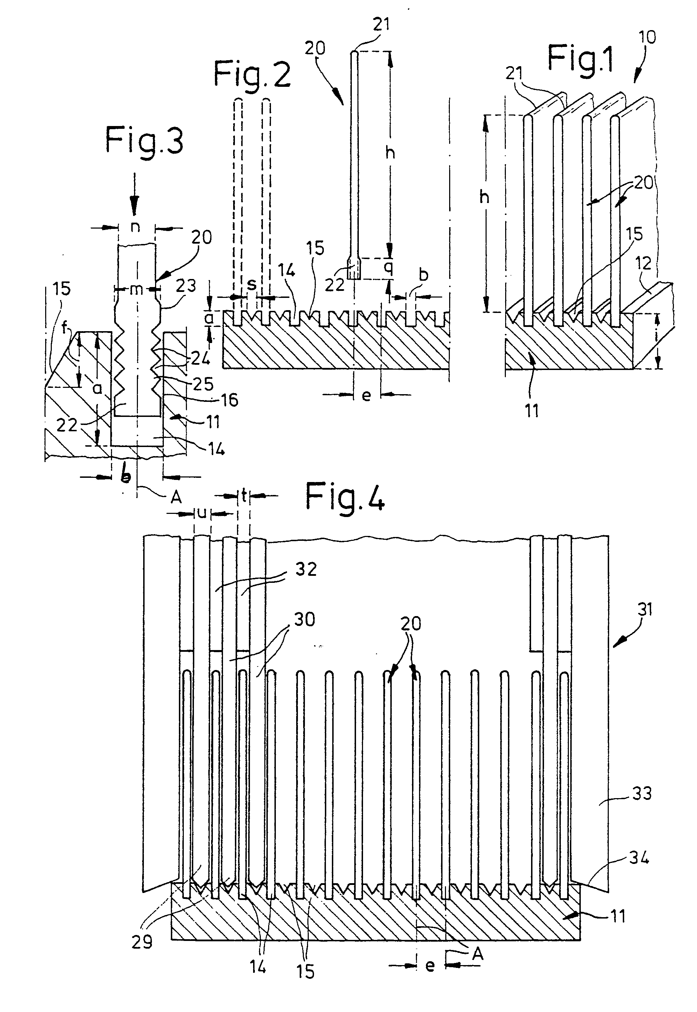

Ein querschnittlich kammartiger Kühlkörper 10 aus Leichtmetall für in der Zeichnung aus Gründen der Übersichtlichkeit nicht weiter dargestellte Halbleiterbauelemente weist gemäß Fig. 1 eine Grundplatte 11 der Dicke i von beispielsweise 15 mm mit von deren Oberfläche 12 aufragenden Kühlrippen 20 auf. Deren freie Länge, nämlich der Abstand h gerundeter freier Rippenkanten 21 von jener Oberfläche 12 der Grundplatte 11, beträgt im ausgewählten Ausführungsbeispiel etwa 56 mm, ihr mittlerer Abstand e voneinander etwa 7 mm.

Insbesondere Fig. 2 läßt deutlich werden, daß die Grundplatte 11 getrennt von jenen Kühlrippen 20 hergestellt wird und zwar — wie auch letztere — auf dem Wege des Strangpressens von Leichtmetallprofilen. In die Grundplatte 11 sind von deren Oberfläche 12 ausgehende Hauptnuten 14 einer Tiefe a von etwa 5 mm mit einer Weite b von etwa halber Tiefe a eingeformt.

In den zwischen jeweils zwei benachbarten Hauptnuten 14 verbleibenden Oberflächenstreifen der Grundplatte 11 ist eine sogenannte Zwischennut 15 dreieckförmigen Quersschnittes eingebracht, deren Tiefe f geringer ist als jene der Hauptnuten 14.

Der stegförmigen Kühlrippe 20 ist an ihrem der freien Rippenkante 21 fernen Querschnittsende ein Sockel 22 angeformt, dessen Breite m etwa der Weite b der Hauptnuten 14 entspricht und größer ist als die Breite n der eigentlichen Kühlrippe 20. Die Höhe q des Sockels 22 ist gleich oder etwas größer als die Tiefe a jener Hauptnut 14. In den Seitenflächen 23 des Sockels 22 sind Sockelnuten 24 zur Bildung seitlich abragender Zähne 25 zu erkennen.

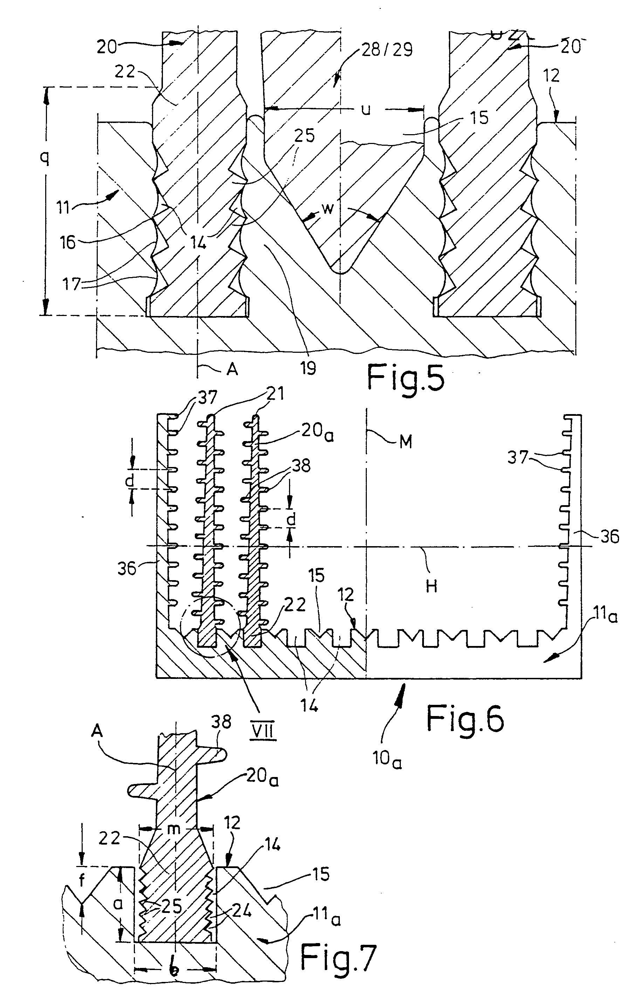

Nach dem Strangpressen der Grundplatte 11 aus einer AlMgSi Legierung werden in deren Haupnuten 14 Kühlrippen 20 mit ihren Sockeln 22 eingesetzt und darin durch plastisches Verformen der Nutenwände 16 festgelegt. Bei diesem Formvorgang werden aus der Nutenwand 16 Werkstoffwülste 17 gegen die Nutenachse A geführt die in die Sockelnuten 24 der eingesetzten Kühlrippe 20 eingreifen, wie dies vor allem Fig. 5 verdeutlicht. Nach diesem Einquetschen wird der so entstandene Kühlkörper 10 warmausgehärtet.

Den Quetschvorgang ermöglichen die Zwischennuten 15, in welche entweder Meißelspitzen 28 oder sich verjüngende Druckkanten 29 von Scheiben 30 eines Rollenkörpers 31 eingesetzt werden. Gemäß Fig. 4 setzt sich der um eine nicht gezeigte Achse drehbare Rollenkörper 31 aus jenen Scheiben 30, diese in Abstand t haltenden Distanzeinlagen 32 und Endplatten 33 zusammen, die mit ihren schrägen Umfangskanten 34 an der Grundplatte 11 geführt sind.

Da die maximale Breite u der sich allmählich erweiternden Meißelspitze 28 oder Druckkante 29 größer ist als die Weite s der Zwischennut 15 — oder der Spitzenwinkel w des Quetschwerkzeuges 28, 29 größer als jener des Nutenquerschnittes — verformen sich die zwischen Haupt- und Zwischennut 14 bzw. 15 stehenden Rippen 19 (Fig. 5) in gewünschter Weise.

Beim Ausführungsbeispiel der Fig. 6, 7 ist an die Grundplatte 11$_a$ beidseits der Kühlkörperachse M eine die Grundplatte 11$_a$ seitlich begren-

zende Rippenwand 36 mit zur Kühlkörperachse M weisenden Nasen 37 angeformt; letztere bestimmen einen Abstand d von etwa 5 mm. Hier sind in die Hauptnuten 14 die Sockel 22 von Kühlrippen $20_a$ eingesetzt, die sich zu ihren Rippenkanten 21 hin verjüngen und mit — Abstände d bestimmenden — Querrippen 38 versehen sind. Die Querrippen 38 der einen Seite der Kühlrippe $20_a$ sind gegenüber jenen der anderen Kühlrippenseite in einem halben Abstand d (also d/2) höhenversetzt; die Nasen 37 und Querrippen 38 einer gemeinsamen Bezugsgeraden H weisen in eine einzige Richtung. So wird bei einem relativ breiten Strömungskanal eine erhebliche Oberflächenvergrößerung durch die Nasen 37 und Querrippen 38 erreicht, weshalb insbesondere dieses Ausführungsbeispiel sowohl für Zwangsbelüftung als auch für Konvektion einsetzbar ist.

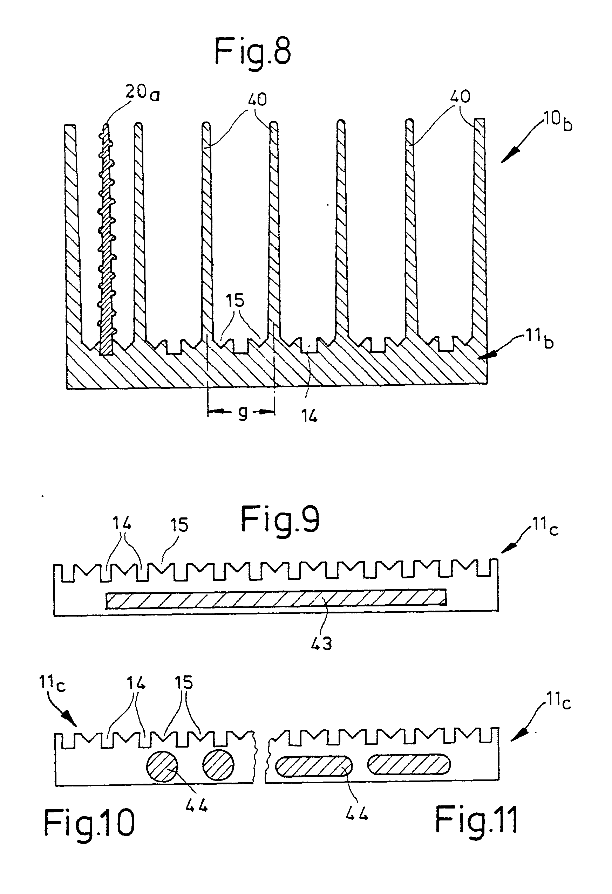

An die Grundplatte $11_b$ der Figur 8 sind beim Strangpressen mehrere Kühlrippen 40 parallel zueinander in Abstand g neben jeweils einer Zwischennut 15 angeformt worden. Zwei Zwischennuten 15 flankieren eine gemeinsame Hauptnut 14. Dieser Kühlkörper $10_b$ bietet ein einfaches Rippenverhältnis an und kann als lange Ausführung für Konvektionskühlung verwendet werden. Wird eine kurze Ausführung gewünscht oder ist der Einsatz bei Zwangsbelüftung vorgesehen, werden in die Hauptnuten 14 gesonderte Kühlrippen $20_a$ eingequetscht.

Da sich bei gleicher Kühlkörperhöhe (i + h) die Rippenoberfläche mit zunehmender Dicke i der Grundplatte 11 reduziert, ist in die Grundplatte $11_c$ der Fig. 9 ein Band 43 aus Kupfer eingefügt. Die Grundplatte $11_c$ der Fig. 10 bzw. 11 weist Runddrähte oder Flachdrähte 44 aus Kupfer auf, die beim Strangpressvorgang im metallischen Verbund in die Leichtmetallmatrix eingebettet worden sind.

## Patentansprüche

1. Verfahren zur Herstellung eines Kühlkörpers (10) für Halbleiterbauelemente, insbesondere durch Strangpressen von Leichtmetall, mit in Abstand zueinander von einer Grundplatte (11) abragenden Kühlrippen (20) etwa stabförmigen Querschnitts, wobei die Grundplatte (11) mit Hauptnuten (14) stranggepresst wird und in die Hauptnuten (14) gesondert hergestellte Kühlrippen (20) eingesetzt werden, dadurch gekennzeichnet, dass mit den Hauptnuten (14) diese flankierende, von Zwischennuten (15) trennende Rippen (19) hergestellt sowie diese Rippen (19) nach dem Einsetzen der Kühlrippen (20) plastisch so verformt werden, dass die Kühlrippen (20) in den Hauptnuten (14) eingequetscht werden.

2. Verfahren nach Anspruch 1, dadurch gekennzeichnet, dass die Rippen (19) zumindest teilweise in Ausnehmungen (24) der Kühlrippen (20) eingepresst werden.

3. Verfahren nach Anspruch 1 oder 2, dadurch gekennzeichnet, dass aus einer Nutenwand (16) der Hauptnut (14) Werkstoffwülste (17) herausgeformt werden, die in Ausnehmungen (24) der Kühlrippen (20) eingreifen.

4. Verfahren nach einem der Ansprüche 1 bis 3, dadurch gekennzeichnet, dass die Zwischennuten (15) mit i.w. dreieckförmigem Querschnitt hergestellt werden.

5. Verfahren nach einem der Ansprüche 1 bis 4, dadurch gekennzeichnet, dass die Hauptnuten (14) mit grösserer Tiefe (a) als die Tiefe (f) der Zwischennuten (15) hergestellt werden.

6. Verfahren nach einem der Ansprüche 1 bis 5, dadurch gekennzeichnet, dass die Kühlrippen (20, 40) wechselweise zum einen mit der Grundplatte (11) einstückig hergestellt sowie zum anderen als gesondert hergestelltes Profil in die Grundplatte (11) eingequetscht werden.

7. Verfahren nach Anspruch 6, dadurch gekennzeichnet, dass zwischen jedem Paar angeformter Kühlrippen (40) in der Grundplatte (11) eine Hauptnut (14) hergestellt wird.

8. Verfahren nach einem der Ansprüche 1 bis 7, dadurch gekennzeichnet, dass die gesondert hergestellten Kühlrippen (20) mit Querrippen (38) versehen werden, welche in Strömungsrichtung verlaufen.

9. Verfahren nach einem der Ansprüche 1 bis 8, dadurch gekennzeichnet, dass die Grundplatte (11c) mit wenigstens einem Band (43), Draht (44) oder dergleichen Ein- oder Auflage aus hochwärmeleitendem Werkstoff versehen wird.

10. Verfahren nach einem der Ansprüche 1 bis 9, dadurch gekennzeichnet, dass die Rippen (19) mit einem in den Zwischennuten (15) abrollenden Werkzeug verformt werden.

11. Verfahren nach einem der Ansprüche 1 bis 10, dadurch gekennzeichnet, dass der Kühlkörper (10) nach dem Verformungsvorgang warm ausgehärtet wird.

12. Werkzeug zur Durchführung des Verfahrens nach Anspruch 10, gekennzeichnet durch von Distanzeinlagen (32) in Abstand gehaltene Druckscheiben (30) mit sich radial verjüngenden Druckkanten (29) dessen maximale Breite (u) größer ist als die Weite (s) der Zwischennuten (15) wobei die freie radiale Länge der Druckscheibe grösser ist als die freie Höhe (h) der Kühlrippe (20).

## Revendications

1. Procédé de fabrication d'un refroidisseur (10) pour éléments semi-conducteurs, en particulier par extrusion d'un métal léger, avec des ailettes de refroidissement (20) de section transversale approximativement en forme de bâtonnet qui font saillie à partir d'une plaque de base (11) en étant à distance les unes des autres, la plaque de base (11) étant extrudée avec des rainures principales (14), et des ailettes de refroidissement (20) fabriquées séparément étant insérées dans les rainures principales (14), caractérisé en ce que des nervures (19) qui flanquent les rainures principales (14), et qui sont séparées par des rainures intermédiaires (15) sont fabriquées avec les rainures principales (14) et en ce que, après insertion des ailettes de refroidissement (20), ces nervures (19) subissent une déformation plastique de telle façon que les ailettes de refroidissement (20) sont insérées par écrasement dans les rainures principales (14).

2. Procédé selon la revendication 1, caractérisé en ce que les nervures (19) sont insérées par compression au moins en partie dans des évidements (24) des ailettes de refroidissement (20).

3. Procédé selon la revendication 1 ou 2, caractérisé en ce qu'à partir d'une paroi (16) de la rainure principale (14) sont formés des bourrelets de matériau (17) qui s'accrochent dans des évidements (24) des ailettes de refroidissement (20).

4. Procédé selon l'une des revendications 1 à 3, caractérisé en ce que les rainures intermédiaires (15) présentent une section transversale sensiblement triangulaire.

5. Procédé selon l'une des revendications 1 à 4, caractérisé en ce que les rainures principales (14) présentent une profondeur (a) plus grande que la profondeur (f) des rainures intermédiaires (15).

6. Procédé selon l'une des revendications 1 à 5, caractérisé en ce que les ailettes de refroidissement (20, 40) sont d'une part fabriquées d'une pièce avec la plaque de base (11) et d'autre part sont insérées par écrasement dans la plaque de base (11) sous forme de profilés fabriqués séparément.

7. Procédé selon la revendication 6, caractérisé en ce qu'une rainure principale (14) est formée entre chaque paire d'ailettes de refroidissement (40) formées dans la plaque de base (11).

8. Procédé selon l'une des revendications 1 à 7, caractérisé en ce que les ailettes de refroidissement (20) fabriquées séparément sont munies de nervures transversales (38) qui s'étendent dans la direction de l'écoulement.

9. Procédé selon l'une des revendications 1 à 8, caractérisé en ce que la plaque de base (IIc) est munie d'au moins une bande (43), un fil (44) ou une insertion ou revêtement analogue en matériau à haute conductivité thermique.

10. Procédé selon l'une des revendications 1 à 9, caractérisé en ce que les nervures (19) sont déformées par un outil qui roule dans les rainures intermédiaires (15).

11. Procédé selon l'une des revendications 1 à 10, caractérisé en ce que le refroidisseur (10) est durci à chaud après le processus de déformation.

12. Outil pour la mise en oeuvre du procédé selon la revendication 10, caractérisé par des disques de pression (30) maintenus écartés par des pièces intermédiaires (32) et présentant des bords de pression (29) qui s'amincissent radialement et dont la largeur maximale (u) est supérieure à la largeur (s) des rainures intermédiaires (15), la longueur radiale libre des disques de pression étant supérieure à la hauteur libre (h) des ailettes de refroidissement (20).

**Claims**

1. Method of manufacturing a heat sink (10) for semiconductor devices, in particular by extrusion of lightweight metal, with cooling ribs (20) of approximately bar-shaped cross section protruding at a distance from one another from a base plate (11), the base plate (11) being extruded with main grooves (14) and separately manufactured cooling ribs (20) being inserted into the main grooves (14), characterized in that the main grooves (14) are manufactured with ribs (19) flanking them and separating them from intermediate grooves (15) and these ribs (19) are plastically deformed after insertion of the cooling ribs (20) in such a way that the cooling ribs (20) are squeezed-in in the main grooves (14).

2. Method according to Claim 1, characterized in that the ribs (19) are pressed at least partially into recesses (24) of the cooling ribs (20).

3. Method according to Claim 1 or 2, characterized in that bulges of material (17) are formed out of a groove wall (16) of the main groove (14) and engage in recesses (24) of the cooling ribs (20).

4. Method according to one of Claims 1 to 3, characterized in that the intermediate grooves (15) are manufactured with essentially triangular cross section.

5. Method according to one of Claims 1 to 4, characterized in that the main grooves (14) are manufactured with greater depth (a) than the depth (f) of the intermediate grooves (15).

6. Method according to one of Claims 1 to 5, characterized in that the cooling ribs (20, 40) are alternately manufactured in one piece with the base plate (11) on the one hand and squeezed into the base plate (11) as a separately manufactured profile on the other hand.

7. Method according to Claim 6 characterized in that a main groove (14) is produced in the base plate (11) between each pair of formed-on cooling ribs (40).

8. Method according to one of Claims 1 to 7, characterized in that the separately manufactured cooling ribs (20) are provided with cross ribs (38), which run in flow direction.

9. Method according to one of Claims 1 to 8, characterized in that the base plate (IIc) is provided with at least one strip (43), wire (44) or similar inlay or overlay of material highly conductive to heat.

10. Method according to one of Claims 1 to 9, characterized in that the ribs (19) are shaped with a tool rolling in the intermediate grooves (15).

11. Method according to one of Claims 1 to 10, characterized in that the heat sink (10) is hot agehardened after the shaping operation.

12. Tool for carrying out the method according to Claim 10, characterized by pressure discs (30) held apart by spacers (32) and having radially tapering pressure edges (29), the maximum width (u) of which is greater than the width (s) of the intermediate grooves (15), the free radial length of the pressure disc being greater than the free height (h) of the cooling rib (20).

EP 0 206 980 B1

Fig.1

Fig.2

Fig.3

Fig.4

1

Fig.5

Fig.6

Fig.7

2

# Fig.8

# Fig.9

# Fig.10

# Fig.11